# EUROPÄISCHE PATENTSCHRIFT

(11) **EP 0 799 166 B1**
(45) Veröffentlichungstag und Bekanntmachung des Hinweises auf die Patenterteilung: **02.09.1998**
(21) Anmeldenummer: 95941586.0
(22) Anmeldetag: 15.12.1995
(51) Int. Cl.: C04B 35/45, C04B 35/653, H01L 39/24

(54) **VERFAHREN ZUR HERSTELLUNG EINES LANGGESTRECKTEN SUPRALEITERS MIT EINER BISMUT-PHASE HOHER SPRUNGTEMPERATUR SOWIE NACH DEM VERFAHREN HERGESTELLTER SUPRALEITER**
PROCESS FOR PRODUCING AN ELONGATE SUPERCONDUCTOR WITH A BISMUTH PHASE HAVING A HIGH TRANSITION TEMPERATURE AND SUPERCONDUCTOR PRODUCED ACCORDING TO THIS PROCESS
PROCEDE DE FABRICATION D'UN SUPRACONDUCTEUR ALLONGE PRESENTANT UNE PHASE BISMUTH A TEMPERATURE DE TRANSITION ELEVEE, ET SUPRACONDUCTEUR FABRIQUE SUIVANT CE PROCEDE

(30) Priorität: 20.12.1994 DE 4445405
(43) Veröffentlichungstag der Anmeldung: 08.10.1997
(73) Patentinhaber: SIEMENS AKTIENGESELLSCHAFT, 80333 München (DE)
(72) Erfinder: JENOVELIS, Alexander, D-91080 Spardorf (DE); WILHELM, Manfred, D-90402 Nürnberg (DE); HELLDÖRFER, Helmut, D-90411 Nürnberg (DE); ROAS, Bernhard, D-91058 Erlangen (DE)
(86) Internationale Anmeldenummer: DE9501798
(87) Internationale Veröffentlichungsnummer: WO9619417

(56) Entgegenhaltungen:
- WO-A-93/22799
- DATABASE WPI Week 9240 Derwent Publications Ltd., London, GB; AN 92-327129 & JP,A,04 233 109 (MITSUBISHI CABLE IND. LTD.) , 21.August 1992
- DATABASE WPI Week 9413 Derwent Publications Ltd., London, GB; AN 94-106540 & JP,A,06 056 426 (SUMITOMO METAL IND. LTD.) , 1.März 1994
- DATABASE WPI Week 9225 Derwent Publications Ltd., London, GB; AN 92-203497 & JP,A,04 132 111 (MITSUBISHI CABLE IND. LTD.) , 6.Mai 1992
- SUPERCOND. SCI. TECHN., Bd. 5, Nr. 10, Oktober 1992 Seiten 591-597, H.K. LIU ET AL. 'Microstructure and defects in Ag-clad Bi-Pb-Sr-Cu-O wires prepared through a controlled melt process' in der Anmeldung erwähnt

## Beschreibung

Die Erfindung bezieht sich auf Verfahren zur Herstellung eines langgestreckten Ein- oder Mehrkernsupraleiters mit mindestens einem in einer Matrix aus Ag-Material eingebetteten Leiterkern, der ein bismuthaltiges Supraleitermaterial mit einer Hoch-T_{c}-Phase vom 2212- und/oder 2223-Typ aufweist. Bei diesem Verfahren werden folgende Verfahrensschritte durchgeführt:
- Es wird ein Aufbau aus dem Matrixmaterial und mindestens einem Kern aus einem Vorprodukt des Supraleitermaterials erstellt,
- der Aufbau wird mittels einer insbesondere querschnittsvermindernden Verformungsbehandlung in einen Rohleiter überführt,
und
- der Rohleiter wird einer Glühbehandlung mit kontrolliertem Schmelzprozeß in einer sauerstoffhaltigen Atmosphäre zur Ausbildung der Hoch-T_{c}-Phase unterzogen.
Die Erfindung betrifft ferner einen nach diesem Verfahren hergestellten Supraleiter.
Ein entsprechendes Verfahren sowie ein nach diesem Verfahren hergestellter Supraleiter sind aus "Supercond. Sci. Technol.", Vol. 5, 1992, Seiten 591 bis 598 zu entnehmen.

Unter bekannte supraleitende Metalloxidverbindungen mit hohen Sprungtemperaturen T_{c} von über 77 K, die deshalb auch als Hoch-Tc-Supraleitermaterialien (Abkürzung: HTSL-Materialien) bezeichnet werden, fallen insbesondere Cuprate auf Basis des Bismut-Stoffsystems Bi-Sr-Ca-Cu-O (Abkürzung: BSCCO) oder Bi(Pb)-Sr-Ca-Cu-O (Abkürzung: B(P)SCCO). Innerhalb dieses Stoffsystems treten zwei supraleitende Phasen auf, die sich durch die Anzahl der Kupfer-Sauerstoff-Netzebenen (-Schichten) innerhalb der kristallinen Einheitszelle unterscheiden. Eine supraleitende Phase mit der ungefähren Zusammensetzung Bi₂Sr₂CaCu₂O_{8+y} hat eine Sprungtemperatur T_{c} von etwa 85 K (sogenannter 2-Schichter/sogenannte 85 K- bzw. 2212-Phase), während die Sprungtemperatur einer supraleitenden Phase mit der ungefähren Zusammensetzung Bi₂Sr₂Ca₂Cu₃O₁₀₊ₓ bei etwa 110 K liegt (sogenannter 3-Schichter oder sogenannte 110 K-bzw. 2223-Phase).

Mit diesen HTSL-Materialien wird versucht, langgestreckte Supraleiter in Draht- oder Bandform herzustellen. Ein hierfür als geeignet angesehenes Verfahren ist die sogenannte "Pulver-im-Rohr-Technik", die prinzipiell von der Herstellung von Supraleitern mit dem klassischen metallischen Supraleitermaterial Nb₃Sn her bekannt ist (vgl. z .B. die DE-AS 1 257 436). Entsprechend dieser Technik wird auch zur Herstellung von Leitern mit HTSL-Material in einen rohrförmigen Träger bzw. in eine Matrix aus einem normalleitenden Material, insbesondere aus Ag oder einer Ag-Legierung, Pulver aus einem Vorprodukt des HTSL-Materials eingebracht, das im allgemeinen noch nicht oder nur zu einem geringen Teil die gewünschte supraleitende Hoch-T_{c}-Phase enthält. Der so zu erhaltende Aufbau wird anschließend mittels Verformungsbehandlungen, die gegebenenfalls durch mindestens eine Wärmebehandlung unterbrochen sein können, auf die gewünschte Enddimension gebracht. Danach wird der so erhaltene draht- oder bandförmige Rohleiter zur Einstellung oder Optimierung seiner supraleitenden Eigenschaften bzw. zur Ausbildung der gewünschten Hoch-T_{c}-Phase mindestens einer Glühbehandlung unterzogen, die wenigstens teilweise in einer sauerstoffhaltigen Atmosphäre, z.B. an Luft, durchgeführt wird (vgl. z.B. "Supercond. Sci. Technol.", Vol. 4, 1991, Seiten 165 bis 171).

Bündelt man in an sich bekannter Weise mehrere entsprechende band- oder drahtförmige Hoch-T_{c}-Supraleiter oder deren Leitervorprodukte, so kann man auch Leiter mit mehreren supraleitenden Leiterkernen, sogenannte Mehrkern- oder Multifilamentleiter, erhalten, die für technische Anwendungen eine Reihe von Vorteilen bieten (vgl. den Beitrag M. Wilhelm et al. mit dem Titel "Fabrication and Properties of Multifilamentary BiPbSrCaCuO-2223 Tapes" des "International Symposium on Superconductivity" (ISS'93), Hiroshima (JP), Oct. 26-29, 1993).

Aus der eingangs genannten Literaturstelle aus " Supercond. Sci. Technol.", Vol. 5, ist entnehmbar, daß die Gefügeeigenschaften solcher reaktionsgeglühter Bandleiterkerne durch partielles Aufschmelzen und nachfolgend kontrollierte Kristallisation der Keramik verbessert, die kritischen Ströme dadurch erhöht und die Magnetfeldabhängigkeit der kritischen Stromdichte herabgesetzt werden können. Das entsprechende Verfahren ist unter der Bezeichnung PFDR-Prozeß (**p**hase **f**ormation-**d**ecomposition-**r**ecovery process) bekannt geworden. Gemäß diesem Verfahren wird ein Nitratgemisch geeigneter Zusammensetzung bei 830°C calciniert und liefert nach Reaktionsglühung bei 845°C an Luft im wesentlichen die 2-Schichter-Verbindung und Erdalkalicuprat. Mit diesem Reaktionsprodukt wird ein bandförmiger Rohleiter mit Silberhülle nach der Pulver-im-Rohr-Technik hergestellt und zur Ausbildung der 3-Schichter-Phase bei 835 bis 838°C geglüht. Ein einmaliges kurzes Anschmelzen der Leiterkerne bei 860°C zwischen der Reaktionsglühung und einer ersten Nachglühung soll eine höhere Kerndichte und eine feine Verteilung von 2-Schichter-Resten und intergranularen Minoritätsphasen in einer 3-Schichter-Matrix bewirken. Auf diese Weise sollen sogenannte Pinning-Zentren erhalten und eine erhöhte Magnetfeldbeständigkeit der Supraleitung bei 77 K gewährleistet werden. Anschließend an die erste Nachglühung bei 838°C wird nochmals kompaktiert und bei 838°C nachgeglüht.

Ein entsprechendes Verfahren mit einem PFDR-Prozeß geht auch aus der WO 93/22799 hervor. Bei diesem bekannten Verfahren wird ebenfalls die im Leiteraufbau erzeugte 2223-Phase bis etwa 860°C kurz angeschmolzen und erfolgt eine Nachglühung bei etwa 839°C, um so in der als Matrix fungierenden 2223-Phase dispergiert einen geringen Anteil der 2212-Phase zu erhalten.

Eine Supraleiterherstellung in technischem Maßstab nach dem PFDR-Verfahren erscheint jedoch problematisch, da die Einstellung eines optimalen Anteils an Schmelze sehr kritisch ist. Das richtige Volumen an Schmelze ist jedoch entscheidend für eine hohe Dichte der Leiterkerne und deren Stromtragfähigkeit. Bei gegebener Zusammensetzung der Kernkeramik ist das Schmelzvolumen abhängig von Temperatur und Glühzeit, aber auch von den Leiterabmessungen. Je größer das Kernvolumen, um so niedriger muß die Anschmelztemperatur sein. Eine dünnflüssige Schmelze, die für eine schnelle, homogene Materialverteilung und damit ein poren- und fremdphasenfreies Wachstum erforderlich ist, entsteht in ausreichender Menge jedoch erst in einem Temperaturbereich, in dem sich die supraleitenden Phasen im B(P)SCCO-Supraleiter wieder zersetzen. Wird wie im Fall des bekannten PFDR-Prozesses eine verhältnismäßig hohe Anschmelztemperatur von 860°C vorgesehen, so besteht die Gefahr, daß sich die Zersetzung der gewünschten supraleitenden Phase bei einer anschließenden Glühung auf vergleichsweise niedrigerem Temperaturniveau nicht mehr ausheilen (rückgängig machen) läßt.

Aufgabe der vorliegenden Erfindung ist es deshalb, ein Verfahren anzugeben, bei dem die genannten Probleme, insbesondere hinsichtlich der Gefahr einer Zersetzung der supraleitenden Phasen, zumindest vermindert sind.

Diese Aufgabe wird erfindungsgemäß dadurch gelost, daß mindestens eine Glühbehandlung mit einer periodisch zwischen einem ersten, höheren Temperaturniveau und einem zweiten, tieferen Temperaturniveau schwankenden Temperaturführung vorgesehen wird, wobei das erste Temperaturniveau höchstens 7°C über der Zersetzungstemperatur der auszubildenden Hoch-T_{c}-Phase und das zweite Temperaturniveau höchstens 9°C unter der Zersetzungstemperatur liegen. Die Zersetzungstemperatur läßt sich dabei exakt dadurch ermitteln, daß bei dieser Temperatur das erstmalige Auftreten einer Phase vom Typ Bi₂Sr₂CuOₓ (= sogenannter 1-Schichter) in dem Kernmaterial zu beobachten ist.

Wie mit dem bekannten PFDR-Verfahren lassen sich mit dem erfindungsgemäßen Verfahren Leiter verhältnismäßig hoher Dichte der Kernkeramik herstellen. Es zeigt sich darüber hinaus, daß die nicht isotherm, sondern erfindungsgemäß mit periodisch schwankender Temperatur geglühten Leiter bei hoher Dichte eine vergleichsweise höhere kritische Stromdichte besitzen. Die gewünschte supraleitende Bi-Phase muß folglich dann in dem Endprodukt zumindest weitgehend vorhanden sein. Außerdem liegt bei dem erfindungsgemäßen Verfahren die Überhitzungstemperatur vorteilhaft niedriger und läßt sich genau und reproduzierbar einstellen.

Vorteilhafte Ausgestaltungen des erfindungsgemäßen Verfahrens gehen aus den abhängigen Ansprüchen hervor.

Die Erfindung wird nachfolgend unter Bezugnahme auf die Zeichnung noch weiter erläutert, in deren Figur 1 schematisch ein Querschnitt durch einen erfindungsgemäß zu glühenden Rohleiter veranschaulicht ist. Die Figuren 2 und 3 zeigen jeweils als Diagramm die Temperaturführung bei einer entsprechenden Glühbehandlung.

Dem Verfahren nach der Erfindung zur Herstellung eines langgestreckten Supraleiters mit Bismut(Bi)-Hoch-T_{C}-Supraleitermaterial läßt sich die an sich bekannte Pulver-im-Rohr-Technik zugrundelegen. Mit dem Verfahren sind langgestreckte Verbundkörper wie z.B. Drähte oder Bänder zu erhalten, die HTSL-Material auf Basis des Stoffsystems Bi-Sr-Ca-Cu-O aufweisend In dem HTSL-Material soll dabei vorzugsweise die sogenannte 2223-Phase zu mehr als 50 Gew.-% vorhanden sein. Zur Herstellung des entsprechenden HTSL-Materials ist es möglich, daß lediglich von den fünf genannten Elementen des Stoffsystems ausgegangen wird. Da das für das erfindungsgemäße Verfahren ausgewählte Stoffsystem aber nur die Basis für das HTSL-Material zu bilden braucht bzw. den Grundtyp darstellt, soll das erfindungsgemäße Verfahren folglich auch mit einschließen, daß einzelne der genannten Elemente teilweise oder auch ganz durch andere Elemente aus der jeweiligen Elementengruppe des Periodensystems in an sich bekannter Weise ersetzt sind. So kann z.B. das Bi auch teilweise durch Sb oder insbesondere durch das die Ausbildung der 2223-Phase fördernde Pb substituiert werden; für die Erdalkalimetalle Sr und Ca kommt beispielsweise auch Ba in Frage. Ferner kann eine teilweise Substitution des Cu auch durch kleinere Mengen anderer Metalle wie z.B. Fe, Co, Ni oder Al erfolgen. Darüber hinaus soll mit eingeschlossen sein, daß dem Stoffsystem noch Zusatzmaterialien (Additive) zugegeben werden können, die zur Verbesserung des Reaktionsmechanismus dienen. So ist es z.B. bekannt, daß Ag- oder Ag₂O-Beigaben aktiv an dem Reakionsgeschehen bei der Ausbildung der gewünschten Hoch-T_{c}-Phase teilnehmen, jedoch nicht in die kristalline Struktur dieser Phase selbst eingebaut werden. Für das Ausführungsbeispiel sei nachfolgend jedoch ein HTSL-Material mit den sechs Komponenten Bi, Pb, Sr, Ca, Cu und O zugrundegelegt, wobei unvermeidbare Verunreinigungen der einzelnen Komponenten mit eingeschlossen sein sollen.

Zur Herstellung eines entsprechenden pulverförmigen Vorproduktes des HTSL-Materials wird von einer bekannten Einwaage ausgegangen, die eine Ausbildung der 110 K- bzw. 2223-Phase ermöglicht. Um die Stöchiometrie dieser Hoch-T_{c}-Phase zu gewährleisten, werden Oxid- und/oder Carbonatpulver der einzelnen Komponenten des Stoffsystems Bi-Pb-Sr-Ca-Cu-O, beispielsweise Pulver aus Bi₂O₃, PbO, SrCO₃, CaO und CuO, in einem Verhältnis 1,8:0,4:2,0:11,8 bis 2,2):3,0:10,3 der einzelnen Komponenten zusammengestellt. Geringfügige Abweichungen der Zusammensetzung der Pulvermischung gegenüber der Stöchiometrie der auszubildenden supraleitenden Hoch-T_{c}-Phase sollen generell möglich sein, sofern eine zumindest teilweise Ausbildung der gewünschten Phase zu gewährleisten ist. Die genannte Pulvermischung wird dann in bekannter Weise beispielsweise in zwei Stufen calciniert, wobei während 3 bis 4 Stunden lang bei etwa 800°C und anschließend z.B. 16 Stunden lang bei etwa 820°C geglüht wird. Das so entstandene Material wird anschließend z.B. in einer Planetenkugelmühle noch vermahlen. Es stellt dann das pulverförmige, auch als "Precursor" oder "Calzinat" bezeichnete Vorprodukt des HTSL-Materials dar und weist eine Vielzahl von ganz verschiedenen Verbindungen der Komponenten des HTSL-Materials, beispielsweise Erdalkaliplumbat (Ca,Sr)₂PbO₄, Erdalkalicuprate verschiedener Zusammensetzung (Ca,Sr)ₓCu_{y}O_{x+y}, CaO, CuO sowie die Perowskite (Bi,Pb)₂Sr₂CuOₓ (= sogenannter 1-Schichter) und (Bi,Pb)₂Sr₂CaCu₂O_{y} (= sogenannter 2-Schichter).

Das so hergestellte Vorprodukt des HTSL-Materials wird anschließend in einen rohrförmigen Trägerkörper aus einem besonderen Matrixmaterial eingebracht und dort vorverdichtet. Als Matrixmaterialien sind vorteilhaft Ag und Ag-Legierungen geeignet, da durch diese Materialien hindurch insbesondere bei erhöhter Temperatur ein Sauerstofftransport aufgrund von Diffusionsmechanismen möglich ist.

Der so erhaltene Aufbau aus dem rohrförmigen Trägerkörper und dem von ihm umschlossenen Kern aus dem Vorproduktmaterial wird anschließend mindestens einer insbesondere querschnittsvermindernden Verformungsbehandlung und einer besonderen Glühbehandlung zur Ausbildung der gewünschten 2223-Phase unterzogen. Im allgemeinen sind zur Ausbildung der gewünschten Endform des Leiters eine Abfolge von mehreren Verformungsbehandlungen und zur Ausbildung der Hoch-T_{c}-Phase des Supraleitermaterials mehrere Glühbehandlungen erforderlich, von denen mindestens eine erfindungsgemäß durchzuführen ist. Zwischen mehreren Glühbehandlungen kann mindestens eine Verformungsbehandlung, beispielsweise ein uniaxiales Pressen, vorgenommen werden, um so insbesondere eine Verbesserung des Texturierungsgrades des Supraleitermaterials zu erreichen.

Für die mindestens eine Verformungsbehandlung kommen alle bekannten Verfahren wie z.B. Strangpressen, Rollen, Walzen, Hämmern und Ziehen in Frage, die auch miteinander kombiniert sein können. Diese Behandlung kann sowohl bei Raumtemperatur als auch bei erhöhter Temperatur durchgeführt werden. Der auf den Kern aus dem behandelten Vorproduktmaterial dabei ausgeübte Druck wird vorteilhaft so eingestellt, daß er zwischen 3 und 20 kbar, vorzugsweise zwischen 5 und 10 kbar, liegt. Auf diese Weise läßt sich ein hochdichter Leiterkern in einer Ag-Matrix erhalten. Nach der mindestens einen Verformungsbehandlung liegt dann ein Rohleiter in Form eines Verbundkörpers mit einer dem angestrebten Endprodukt zumindest weitgehend entsprechenden Gestalt, vorzugsweise in Bandform, vor.

Mit den vorstehend beschriebenen Verfahrensschritten einer Calcinierung zu einem Vorprodukt des Supraleitermaterials und einer Verformung dieses Vorproduktes in einem Trägerrohr aus dem Matrixmaterial können nicht nur Einkernleiter hergestellt werden. Vielmehr lassen sich diese Verfahrensschritte auch zu einer Herstellung von Mehrkern- bzw. Multifilamentleitern mittels einer an sich bekannten Bündelungstechnik zugrundelegen. Gemäß dieser Technik ist z.B. eine Bündelung von mehreren Trägerrohren, die jeweils einen Kern aus dem calcinierten Vorproduktmaterial enthalten, in einem Hüllrohr insbesondere auch dem Matrixmaterial möglich. Dieser Aufbau wird dann mindestens einmal verformt und stellt so einen Mehrkern-Rohleiter dar. Selbstverständlich können auch vorverformte und/oder gegebenenfalls vorgeglühte Einkern-Rohleiter in ein entsprechendes Hüllrohr eingebracht und dann zu einem Mehrkern-Rohleiter mittels der mindestens einen Verformungsbehandlung weiterverarbeitet werden.

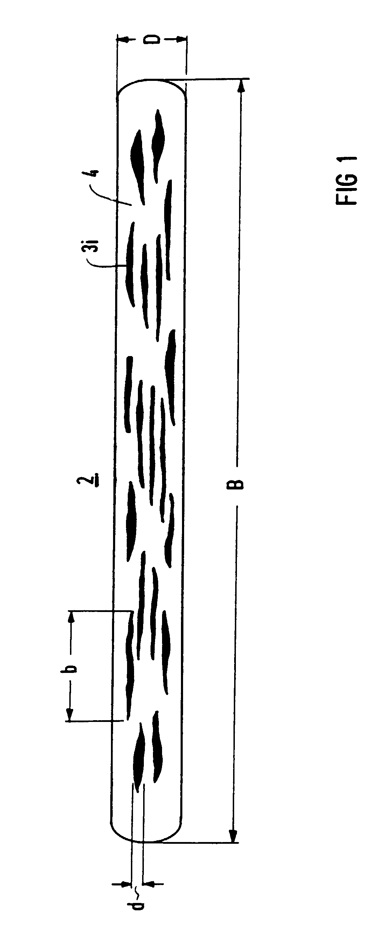

Ein Ausführungsbeispiel eines entsprechenden, nach einer Abfolge von Preß- und Walzvorgängen zu erhaltenden MehrkernRohleiters eines erfindungsgemäß herzustellenden bandförmigen Supraleiters geht aus Figur 1 der Zeichung als Querschnitt hervor. Der Rohleiter ist allgemein mit 2 bezeichnet. Seine beispielsweise 19 Leiterkerne 3i (mit 1 ≤ i ≤ 19) aus dem Vorproduktmaterial sind in einer Matrix 4 aus Ag eingebettet. Der Rohleiter 2 hat z.B. die nachfolgend aufgeführten, für Bandformen typischen Abmessungen:
- Banddicke D:: 100 µm bis 500 µm,
vorzugsweise 200 µm bis 350 µm
- Bandbreite B:: 2 mm bis 6 mm,
vorzugsweise 3,5 mm bis 4,5 mm;
- Leiterkerndicke d:: 10 µm bis 50 µm,
vorzugsweise 20 µm bis 35 µm;
- Leiterkernbreite b:: 30 um bis 200 µm,
vorzugsweise 150 µm bis 180 µm.

Die entsprechenden typischen Abmessungen für einen bandförmigen Einkern-Rohleiter sind:
50 µm ≤ D ≤ 400 µm, vorzugsweise 100 µm ≤ D ≤ 200 µm;
1,5 mm ≤ B ≤ 5 mm, vorzugsweise 2 mm ≤ B ≤ 3 mm;
10 µm ≤ d ≤ 40 µm, vorzugsweise 20 µm ≤ d ≤ 30 µm;
500 µm ≤ b ≤ 4,5 mm, vorzugsweise 1,5 mm ≤ b ≤ 2,5 mm.

Ein Rohleiter z.B. mit einem aus Figur 1 ersichtlichen Aufbau weist im allgemeinen noch nicht die gewünschten supraleitenden Eigenschaften auf. D.h., in seinem mindestens einen Kern liegt noch nicht die gewünschte supraleitende Phase, insbesondere vom 2223-Typ, in hinreichender Reinheit und mit einer eine hohe kritische Stromdichte gewährleistenden Textur vor. Deshalb ist erfindungsgemäß mindestens eine besondere Glühbehandlung des Rohleiters mit einer periodisch wechselnden (quasi "schwingenden"), nicht-isothermen Temperaturführung vorgesehen. Die Glühbehandlung wird in einer sauerstoffhaltigen Atmosphäre, beispielsweise in Luft oder in einer sonstigen Atmosphäre mit einem Sauerstoffpartialdruck zwischen 1 und 200 mbar durchgeführt.

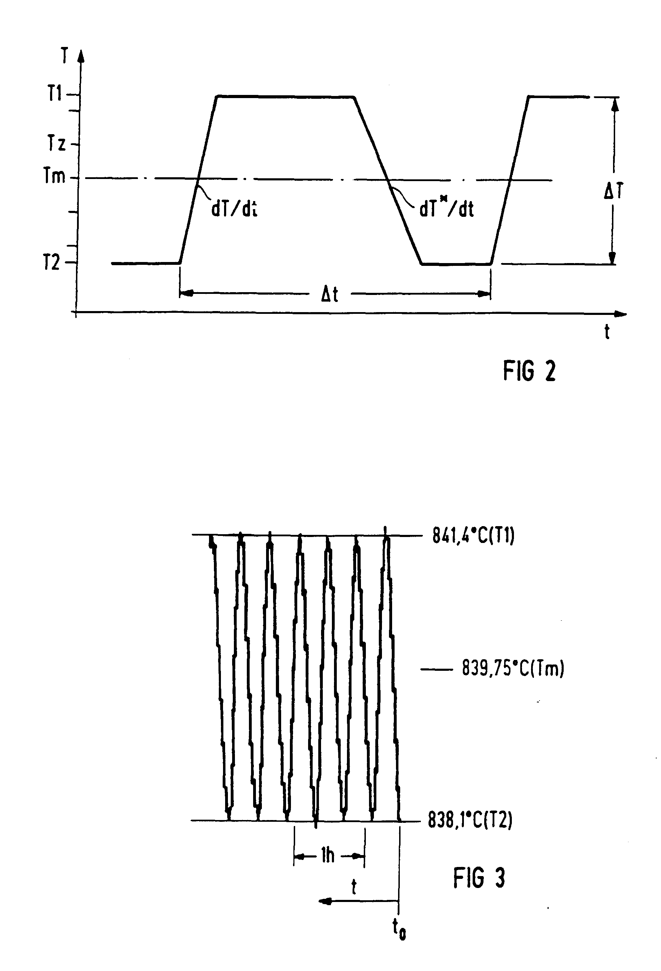

In Figur 2 ist diese Temperaturführung schematisch in einem Diagramm dargestellt. Dabei sind in Abszissenrichtung die Zeit t (in willkürlichen Einheiten) und in Ordinatenrichtung die Glühtemperatur T (in 1°C-Schritten) aufgetragen. In dem Diagramm sind bezeichnet
mit T1 eine erste Temperatur auf einem höheren Temperaturniveau,
mit T2 eine zweite Temperatur auf einem vergleichsweise niedrigeren Temperaturniveau,
mit ΔT (= T1-T2) der Temperaturunterschied (= Schwingungsamplitude) zwischen den beiden Glühtemperaturen T1 und T2,
mit Δt die Dauer einer Schwingungsperiode, die sich aus den Zeiten für die beiden Glühintervalle auf der Temperatur T1 und der Temperatur T2 zusammensetzt,
(dT/dt) die mittlere Aufheizrate von der Temperatur T2 auf die Temperatur T1
und
mit (dT*/dt) die mittlere Abkühlrate von der Temperatur T1 auf die Temperatur T2.

Die Temperatur T1 ist dabei soweit oberhalb der Zersetzungstemperatur Tz der auszubildenden Hoch-T_{c}-Phase gelegt, daß in den Glühintervallen mit der höheren Temperatur T1 eine dünnflüssige Schmelze entsteht, die an alle Stellen des Gefüges zwischen die einzelnen Phasen vordringen kann und den für die Reaktion notwendigen Teilchentransport zu diesen Stellen gewährleistet. Demgemäß sollen die supraleitenden Phasen vom Typ 2212 und/oder 2223 bei der höheren Temperatur T1 bereits aufzuschmelzen oder sich zu zersetzen beginnen. In den jeweils nachfolgenden Glühintervallen mit der erniedrigten Temperatur T2 (unterhalb von Tz) können dann die supraleitenden Phasen ausheilen und in alle Richtungen wachsen, da sie vollständig mit der nun wieder dickflüssig gewordenen Schmelze benetzt sind und kein Teilchentransport über größere Strecken mehr notwendig ist. Die Temperaturführung muß so gewählt sein, daß im Laufe der Zeit mehr supraleitende Phase in den Intervallen mit niedrigerer Glühtemperatur T2 entsteht, als in den Intervallen höherer Glühtemperatur T1 verlorengeht. Die Verweildauer auf den verschiedenen Temperaturniveaus kann dabei unterschiedlich sein. Außerdem sollte gewährleistet werden, daß die erste Glühung als sogenannte Reaktionsglühung des Rohleiters mit einem Intervall niedrigerer Glühtemperatur beginnt, da beim ersten Hochheizen des Rohleiters ein zu heftiges Aufschmelzen des Vorproduktmaterials die Bildung texturierter, bleihaltiger Bi-2212-Kristalle an der Grenzfläche zu dem Ag-Material der Matrix verhindern würde. Diese Kristalle sind als Keime wesentlich für die Ausbildung einer guten Textur im gesamten supraleitenden Kern. Spätestens bei dem ersten Hochheizen verschwindet praktisch vollständig eine eventuell noch vorhandene 1-Schichter-Phase sehr schnell und zwar bei einer Temperatur, noch bevor erstmals die Schmelztemperatur Tz erreicht wird.

Die folgende nicht-isotherme Temperaturführung wird für die Reaktions- und Ausheilglühungen erfindungsgemäß vorgesehen:
- Die erste höhere Glühtemperatur T1 soll höchstens 7 K, vorzugsweise höchstens 5 K, insbesondere höchstens 3 K, oberhalb der Zersetzungstemperatur Tz des keramischen Supraleitermaterials in der Matrix aus dem Ag-Material liegen. Die Zersetzungstemperatur Tz ist definitionsgemäß die Temperatur, bei der man nach schnellem Abkühlen des Leiterendproduktes (Silberbandleiters) mit Hilfe der Röntgendiffraktometrie eine Bildung der bis dahin noch nicht oder nicht mehr vorhandenen Bi-2201-Phase im Keramikkern nachweisen kann. Tz liegt je nach Sauerstoffpartialdruck und Leitergeometrie zwischen etwa 800°C und 880°C. Die zweite, niedrigere Glühtemperatur T2 soll höchstens 9 K, vorzugsweise höchstens 7 K, insbesondere höchstens 5 K, unterhalb der Zersetzungstemperatur Tz liegen. Im allgemeinen wird für den Temperaturbereich zwischen T2 und T1 eine mittlere Glühtemperatur
   Tm = (T1)/2 + (T2)/2 gewählt, die 0,5 K bis 3 K unter der Zersetzungstemperatur Tz des keramischen Supraleitermaterials liegt.
- Die Amplitude ΔT der Glühtemperaturvariation (-schwingung) soll zwischen 1 K und 10 K liegen.
- Die Dauer einer Schwingungsperiode Δt soll zwischen 2 Minuten und 200 Minuten liegen.
- Der Temperaturverlauf als Funktion der Zeit t sollte vorteilhaft nach Art einer Sinusfunktion oder einer Trapezfunktion mit Aufheiz- und Abkühlraten (dT/dt) bzw. (dT∗/dt) zwischen 10 K/min und 0,01 K/min in einem Temperatur-Zeit-Diagramm (vgl. Figur 2) beschrieben werden.

Figur 3 zeigt als Diagramm in einer Figur 2 entsprechenden Darstellung eine erfindungsgemäße Temperaturführung für ein konkretes Ausführungsbeispiel eines Einkern-Rohleiters mit Beginn des periodischen Temperaturwechsels bei einer Zeit tₒ und der Temperatur T2. Zur Herstellung des Rohleiters wurde ein Silberrohr mit 8 mm Außendurchmesser und 1 mm Wandstärke mit Calcinat der nominellen Zusammensetzung
Bi_{1,84}Pb_{0,35}Sr_{2,0}Ca_{2,1}Cu_{3,0}O₁₀+x gefüllt und bis zu einem Durchmesser von 0,5 mm gehämmert. Nach Überziehen mit einem zweiten Ag-Rohr derselben Abmessungen (8 mm bzw. 1 mm) wurde der Verbund bis 1,5 mm Durchmesser gehämmert und dann bis 1,3 mm Durchmesser gezogen und schließlich zu einem Band von 0,1 mm Dicke gewalzt. Der Rohleiter wurde anschließend in einem Rohrofen dreimal der dem Diagramm der Figur 3 entnehmbaren Glühbehandlung unter Luft unterzogen und zur Kompaktierung bzw. Texturierung nach jeder Glühbehandlung mit einem Druck von 10 kbar uniaxial gepreßt. Folgende Werte für die einzelnen Glühbehandlungen wurden vorgesehen:
T1 = 841,4°C, T2 = 838,1°C, Tm = 839,75°C
ΔT = 3,3 K
(dT/dt) = (dT*/dt) = 0,3 K/min
ΔT = 22 min.

Die Zersetzungstemperatur lag in diesem Fall bei etwa 840°C. Entsprechend geglühte Endprodukte zeigten reproduzierbar kritische Stromdichten von deutlich über 4 x 10⁴ A/cm² im Nullfeld bei 77 K.

Gemäß den vorstehenden Ausführungsbeispielen wurde davon ausgegangen, daß die langgestreckten, insbesondere bandförmigen Supraleiter mittels einer Pulver-im-Rohr-Technik erfindungsgemäß zu glühen sind. Die Erfindung ist jedoch nicht auf eine derartige Technik beschränkt. Sie ist ebensogut für die Herstellung von Supraleitern mit einer Bi-2212-Phase oder Bi-2223-Phase geeignet, die auch nachträglich zusammengesetzte Umhüllungen aus Ag-Material um ein Vorprodukt des Supraleitermaterials aufweisen. Ein Beispiel einer derartig zusammengesetzten Umhüllung geht aus der DE-OS 43 08 681 hervor. Gemäß dieser Veröffentlichung ist das Vorprodukt über eine Siebdrucktechnik in Pastenform auf einen bandförmigen Ag-Träger aufzubringen. Die noch freien Oberflächenteile dieses Vorproduktes müssen dann mit Hilfe eines beispielsweise folienartigen Abdeckelementes abgedichtet werden, bevor der so gewonnene Aufbau zu einem Rohrleiter weiter verarbeitet wird, der dann erfindungsgemäß zu glühen ist.

Das erfindungsgemäße Verfahren ist auch nicht nur auf die Herstellung von Ein- oder Mehrkernsupraleitern mit im wesentlichen nur der Bi-2223-Phase beschränkt. Ebensogut sind mit diesem Verfahren auch entsprechende Supraleiter herstellbar, die hauptsächlich nur die Bi-2212-Phase oder ein Phasengemisch aus der Bi-2212-Phase und der Bi-2223-Phase aufweisen. Auch in diesen Fällen gilt die genannte Bestimmung der Schmelztemperatur Tz.

## Patentansprüche

1. Verfahren zur Herstellung eines langgestreckten Ein- oder Mehrkernsupraleiters mit mindestens einem in einer Matrix aus Ag-Material eingebetteten Leiterkern, der ein wismuthaltiges Supraleitermaterial mit einer Hoch-T_{c}-Phase vom 2212-und/oder 2223-Typ aufweist, bei welchem Verfahren
- ein Aufbau aus dem Matrixmaterial und mindestens einem Kern aus einem Vorprodukt des Supraleitermaterials erstellt wird,
- der Aufbau mittels einer insbesondere querschnittsvermindernden Verformungsbehandlung in einen Rohleiter überführt wird
und
- der Rohleiter einer Glühbehandlung mit kontrolliertem Schmelzprozeß in einer sauerstoffhaltigen Atmosphäre zur Ausbildung der Hoch-T_{c}-Phase unterzogen wird,
**dadurch gekennzeichnet** daß mindestens eine Glühbehandlung mit einer periodisch zwischen einem ersten, höheren Temperaturniveau (T1) und einem zweiten, tieferen Temperaturniveau (T2) schwankenden Temperaturführung vorgesehen wird, wobei das erste Temperaturniveau (T1) höchstens 7 K über der Zersetzungstemperatur (Tz) der auszubildenden Hoch-T_{c}-Phase und das zweite Temperaturniveau (T2) höchstens 9 K unter der Zersetzungstemperatur (Tz) liegen.

2. Verfahren nach Anspruch 1, **dadurch gekennzeichnet,** daß eine höhere Temperatur (T1) von höchstens 5 K, vorzugsweise von höchstens 3 K über der Zersetzungstemperatur (Tz) der Hoch-T_{c}-Phase vorgesehen wird.

3. Verfahren nach Anspruch 1 oder 2, **dadurch gekennzeichnet,** daß eine tiefere Temperatur (T2) von höchstens 7 K, vorzugsweise von höchstens 5 K unter der Zersetzungstemperatur (Tz) der Hoch-T_{c}-Phase vorgesehen wird.

4. Verfahren nach einem der Ansprüche 1 bis 3, **dadurch gekennzeichnet,** daß ein Temperaturunterschied (ΔT) zwischen der höheren und der tieferen Temperatur (T1 bzw. T2) zwischen 1 und 10 K vorgesehen wird.

5. Verfahren nach einem der Ansprüche 1 bis 4, **dadurch gekennzeichnet,** daß eine Periode der Glühbehandlung mit einer Dauer zwischen 2 Minuten und 200 Minuten vorgesehen wird.

6. Verfahren nach einem der Ansprüche 1 bis 5, **dadurch gekennzeichnet,** daß eine mittlere Aufheizrate (dT/dt) von der tieferen Temperatur (T2) auf die höhere Temperatur (T1) sowie eine mittlere Abkühlrate (dT'/dt) von der höheren Temperatur (T1) auf die tiefere Temperatur (T2) zwischen jeweils 0,01 K/min und 10 K/min vorgesehen werden.

7. Verfahren nach einem der Ansprüche 1 bis 6, **dadurch gekennzeichnet,** daß die Glühbehandlung des Rohleiters (2) zur Ausbildung der Hoch-T_{c}-Phase bei einem Sauerstoff-Partialdruck zwischen 1 mbar und 200 mbar vorgenommen wird.

8. Verfahren nach einem der Ansprüche 1 bis 7, **dadurch gekennzeichnet,** daß zur Herstellung des Vorproduktmaterials wenigstens eine der metallischen Komponenten des genannten Typs der Hoch-T_{c}-Phase wenigstens teilweise durch eine weitere metallische Komponente, insbesondere das Bi der Bi-Komponente teilweise durch Pb ersezt wird und/oder eine von der Basis der Zusammensetzung der Hoch-T_{c}-Phase abweichende Stöchiometrie vorgesehen wird, sofern eine zumindest teilweise Ausbildung der Hoch-T_{c}-Phase gewährleistet ist.

9. Verfahren nach einem der Ansprüche 1 bis 8, **dadurch gekennzeichnet,** daß der Aufbau aus dem Matrixmaterial und dem mindestens einen Kern aus dem Vorproduktmaterial nach einer Pulver-im-Rohr-Technik erstellt wird.

10. Verfahren nach einem der Ansprüche 1 bis 9,**dadurch gekennzeichnet,** daß mehrere Glühbehandlungen vorgesehen werden, zwischen denen der Leiter einer uniaxialen Preßbehandlung unterzogen wird.

11. Langgestreckter Ein- oder Mehrkernsupraleiter mit mindestens einem in einer Matrix aus Ag-Material eingebetteten Leiterkern, der ein wismuthaltiges Supraleitermaterial mit einer Hoch-T_{c}-Phase vom 2212- und/oder 2223-Typ aufweist, **gekennzeichnet** durch mindestens eine Glühbehandlung mit einer periodisch zwischen einem ersten, höheren Temperaturniveau (T1) und einem zweiten, tieferen Temperaturniveau (T2) schwankenden Temperaturführung, wobei das erste Temperaturniveau (T1) höchstens 7 K über der Zersetzungstemperatur (Tz) der auszubildenden Hoch-T_{c}-Phase und das zweite Temperaturniveau (T2) höchstens 9 K unter der Zersetzungstemperatur (Tz) liegen.

12. Mehrkernsupraleiter nach Anspruch 11, **gekennzeichnet** durch ein Herstellungsverfahren nach einem der Ansprüche 2 bis 10.

## Claims

1. Process for the production cf an elongated one- cr multi-core superconductor having at least one conductor core which is embedded in a matrix of Ag material and comprises a bismuth-containing superconductor material with a high T_{c} phase of the 2212 and/or 2223 type, in which process
- a structure is established from the matrix material and at least one core of a precursor of the superconductor material,
- the structure is converted into a raw conductor by means of a forming treatment which, in particular, reduces the cross-section,
and
- the raw conductor is subjected to an annealing treatment with a controlled melting process in an oxygen-containing atmosphere for formation of the high T_{c} phase,
characterized in that at least one annealing treatment with a temperature programme which fluctuates periodically between a first higher temperature level (T1) and a second lower temperature level (T2) is provided, the first temperature level (T1) being not more than 7 K above the decomposition temperature (Tz) of the high T_{c} phase to be formed and the second temperature level (T2) being not more than 9 K below the decomposition temperature (Tz).

2. Process according to claim 1, characterized in that a higher temperature (T1) of not more than 5 K, preferably not more than 3 K, abcve the decomposition temperature (Tz) of the high T_{c} phase is provided.

3. Process according to claim 1 or 2, characterized in that a lower temperature (T2) of not more than 7 K, preferably not more than 5 K, below the decomposition temperature (Tz) of the high T_{c} phase is provided.

4. Process according to one of claims 1 to 3, characterized in that a temperature difference (ΔT) between the higher and the lower temperature (T1 and T2) of between 1 and 10 K is provided.

5. Process according to one of claims 1 to 4, characterized in that a period of the annealing treatment with a duration of between 2 minutes and 200 minutes is provided.

6. Process according to one of claims 1 to 5, characterized in that an average heating-up rate (dT/dt) from the lower temperature (T2) to the higher temperature (T1) and an average cooling rate (dT*/dt) from the higher temperature (T1) to the lower temperature (T2) of between in each case 0.01 K/min and 10 K/min are provided.

7. Process according to one of claims 1 to 6, characterized in that the annealing treatment on the raw conductor (2) for formation of the high T_{c} phase is carried out under an oxygen partial pressure of between 1 mbar and 200 mbar.

8. Process according to one of claims 1 to 7, characterized in that, to produce the precursor material, at least one of the metallic components of the type mentioned of high T_{c} phase is replaced at least in part by another metallic component, in particular the Bi of the Bi component is replaced in part by Pb, and/or a stoichiometry which deviates from the basis of the composition of the high T_{c} phase is provided, as long as at least partial formation of the high T_{c} phase is ensured.

9. Process according to one of claims 1 to 8, characterized in that the structure of the matrix material and the minimum of one core of the precursor material is established by a powder-in-tube technique.

10. Process according to one of claims 1 to 9, characterized in that several annealing treatments, between which the conductor is subjected to a uniaxial pressing treatment, are provided.

11. Elongated one- or multi-core superconductor having at least one conductor core which is embedded in a matrix of Ag material and comprises a bismuth-containing superconductor material with a high T_{c} phase of the 2212 and/or 2223 type, characterized by at least one annealing treatment with a temperature programme which fluctuates periodically between a first higher temperature level (T1) and a second lower temperature level (T2), the first temperature level (T1) being not more than 7 K above the decomposition temperature (Tz) of the high T_{c} phase to be formed and the second temperature level (T2) being not more than 9 K below the decomposition temperature (Tz).

12. Multi-core superconductor according to claim 11, characterized by a production process according to one of claims 2 to 10.

## Revendications

1. Procédé de fabrication d'un supraconducteur allongé à un ou plusieurs noyau(x) avec au moins un noyau conducteur inséré dans une matrice faite d'un matériau à base d'argent, lequel noyau comprend un matériau supraconducteur contenant du bismuth et présentant une phase à Tc élevée de type 2212 et/ou 2223, procédé dans lequel
- une structure formée du matériau de matrice et d'au moins un noyau formé d'un précurseur du matériau supraconducteur est produite,
- la structure est transformée en un conducteur brut au moyen d'un traitement de déformation qui, notamment, réduit sa section.
et
- le conducteur brut est soumis à un traitement de calcination avec processus de fusion contrôlé dans une atmosphère contenant de l'oxygène en vue de la formation de la phase à Tc élevée,
caractérisé en ce que l'on prévoit au moins un traitement de calcination avec contrôle de la température qui oscille de manière périodique entre un premier niveau de température plus élevé (T1) et un second niveau de température plus bas (T2), le premier niveau de température (T1) étant supérieur de 7 K au maximum à la température de décomposition (Tz) de la phase à Tc élevée devant être formée et le second niveau de température (T2) étant inférieur de 9 K au maximum à la température de décomposition (Tz).

2. Procédé selon la revendication 1, caractérisé en ce que l'on prévoit une température plus haute (T1) supérieure de 5 K au maximum. de préférence supérieure de 3 K au maximum. à la température de décomposition (Tz) de la phase à Tc élevée.

3. Procédé selon la revendication 1 ou 2, caractérisé en ce que l'on prévoit une température plus basse (T2) inférieure de 7 K au maximum, de préférence inférieure de 5 K au maximum, à la température de décomposition (Tz) de la phase à Tc élevée.

4. Procédé selon l'une des revendications 1 à 3, caractérisé en ce que l'on prévoit une différence de température (Δt) comprise entre 1 et 10 K entre la température plus haute et la température plus basse (T1 resp. T2).

5. Procédé selon l'une des revendications 1 à 4, caractérisé en ce que l'on prévoit une période de traitement de calcination durant entre 2 minutes et 200 minutes.

6. Procédé selon l'une des revendications 1 à 5, caractérisé en ce que l'on prévoit une vitesse moyenne d'échauffement (dT/dt) de la température plus basse (T2) à la température plus haute (T1) ainsi qu'une vitesse moyenne de refroidissement (dT'/dt) de la température plus haute (T1) à la température plus basse (T2) qui sont comprises, à chaque fois, entre 0,01 K/min et 10 K/min.

7. Procédé selon l'une des revendications 1 à 6, caractérisé en ce que le traitement de calcination du conducteur brut (2) en vue de la formation de la phase à Tc élevée est effectué avec une pression partielle d'oxygène comprise entre 1 mbar et 200 mbar.

8. Procédé selon l'une des revendications 1 à 7, caractérisé en ce que, pour fabriquer le matériau précurseur, on remplace au moins un des constituants métalliques du type mentionné de la phase à Tc élevée, au moins partiellement, par un autre constituant métallique - le bismuth du constituant au bismuth, notamment, est remplacé partiellement par au plomb -, et/ou on prévoit une stoechiométrie qui s'écarte de la base ce la composition de la phase à Tc élevée, dans la mesure où une formation, au moins partielle, de la phase à Tc élevée est garantie.

9. Procédé selon l'une des revendications 1 à 8, caractérisé en ce que la structure formée du matériau de matrice et du - au moins un - noyau formé du matériau précurseur est produite selon une technique de poudre en tube.

10. Procédé selon l'une des revendications 1 à 9, caractérisé en ce que l'on prévoit plusieurs traitements de calcination, entre lesquels le conducteur est soumis à un traitement de pressage suivant un seul axe.

11. Supraconducteur allongé à un ou plusieurs noyau(x) avec au moins un noyau conducteur inséré dans une matrice faite d'un matériau à base d'argent, lequel noyau comprend un matériau supraconducteur contenant du bismuth et présentant une phase à Tc élevée de type 2212 et/ou 2223, caractérisé par au moins un traitement de calcination avec contrôle de la température qui oscille de manière périodique entre un premier niveau de température plus élevé (T1) et un second niveau de température plus bas (T2), le premier niveau de température (T1) étant supérieur de 7 K au maximum à la température de décomposition (Tz) de la phase à Tc élevée devant être formée et le second niveau de température (T2) étant inférieur de 9 K au maximum à la température de décomposition (Tz).

12. Supraconducteur à plusieurs noyaux selon la revendication 11. caractérisé par un procédé de fabrication selon l'une des revendications 2 à 10.
